Europäisches Patentamt

European Patent Office

Office européen des brevets

(11) Veröffentlichungsnummer : **0 508 062 B1**

(19)

(12)                          **EUROPÄISCHE PATENTSCHRIFT**

(45) Veröffentlichungstag der Patentschrift :          (51) Int. Cl.⁶ : **G01R 31/28**
19.07.95 Patentblatt 95/29

(21) Anmeldenummer : **92102298.4**

(22) Anmeldetag : **12.02.92**

(54) Verfahren und Vorrichtung zur Prüfung einer elektrischen Leiteranordnung.

(30) Priorität : **10.04.91 SU 4925774**
              **16.10.91 DE 4134193**

(43) Veröffentlichungstag der Anmeldung :
**14.10.92 Patentblatt 92/42**

(45) Bekanntmachung des Hinweises auf die
Patenterteilung :
**19.07.95 Patentblatt 95/29**

(84) Benannte Vertragsstaaten :
**CH DE FR GB IT LI**

(56) Entgegenhaltungen :
**DE-A- 2 409 279**

(73) Patentinhaber : **ATG ELECTRONIC GmbH**
**Zum Schlag 3**
**D-97877 Wertheim (DE)**

(72) Erfinder : **Prokopp, Manfred**
**Am Felder 27**
**W-6980 Wertheim-Reicholzheim (DE)**
Erfinder : **Schen, Alexandr Chanevitsch,**
**Dipl.-Math.**
**Moskvina 5; K. 5/2**
**SU-03031 Moskau (SU)**
Erfinder : **Poskatscheev, Andrey Jurevitsch,**
**Dipl.-Phys.**
**Onejska 17, K. I, 6/2**
**SU-25438 Moskau (SU)**
Erfinder : **Janenko, Evgeniy Oktavievitsch,**
**Dipl.-Phys.**
**Bul. Rainisa 43, K. 459/2**
**SU-23373 Moskau (SU)**

(74) Vertreter : **Grosse, Rainer, Dipl.-Ing. et al**
**Patentanwalt,**
**Maybachstrasse 6A**
**D-70469 Stuttgart (DE)**

EP 0 508 062 B1

## Beschreibung

Die Erfindung betrifft ein Verfahren zur Prüfung einer elektrischen Leiteranordnung, insbesondere von Leiterbahnen einer Leiterplatte, auf Kurzschluß und/oder Unterbrechung, bei dem Prüfpunkte der Leiteranordnung mittels Meßsonden kontaktiert und die ermittelten Meßergebnisse ausgewertet werden.

Das vorstehend genannte Verfahren ist bekannt. Für die Prüfung werden mittels der genannten Meßsonden die Prüfpunkte einer Leiteranordnung, beispielsweise Leiterbahnen einer Leiterplatte, kontaktiert, wobei stets mittels eines Meßsondenpaares ein Prüfstrom über die Leiteranordnung geschickt wird. Hierdurch läßt sich feststellen, ob die Leiteranordnung einen Kurzschluß oder eine Unterbrechung aufweist. Üblicherweise wird zu Beginn einer Prüfung einer Charge von zu prüfenden Leiteranordnungen zunächst ein intakter Prüfling der Prüfung unterzogen, wobei die ermittelten Meßergebnisse als Referenz abgespeichert werden. Bei der nachfolgenden Prüfung der übrigen Leiteranordnungen wird dann der Vergleich mit diesen Meßergebnissen durchgeführt. Sind Unterschiede feststellbar, so weist die entsprechende Leiteranordnung einen Fehler auf. Fehlerhafte Prüflinge werden gekennzeichnet und/oder aussortiert. Vorzugsweise wird der genaue Fehlerort angegeben.

Das bekannte Verfahren erfordert eine Vielzahl von Prüfschritten, da beispielsweise für eine Isolationsprüfung einzelner Leiterbahnen einer Leiterplatte untereinander jede Leiterbahn gegenüber jeder anderen Leiterbahn durch entsprechendes Anfahren mit den Meßsonden geprüft werden muß. Die Anzahl X der Prüfschritte ergibt sich nach der Beziehung:

$$X = \frac{y^2 - y}{2},$$

wobei y die Zahl der zu prüfenden Netze (Leiterbahnen) angibt. Wird einmal unterstellt, daß eine Leiterplatte 1000 voneinander isolierte Leiterbahnen aufweist, so hat dies für die genannte Prüfung ca. 500.000 Prüfschritte zur Folge. Das Bewegen der Meßsonden zur Durchführung dieser Prüfschritte erfordert entsprechend lange Zeit.

Ein Verfahren gemäß dem Oberbegriff des Anspruchs 1 und eine Vorrichtung gemäß dem Oberbegriff des Anspruchs 20 sind z.B. aus DE-A-2 409 279 bereits bekannt.

Aufgabe der Erfindung ist es daher, ein Verfahren zur Prüfung anzugeben, das bei hoher Prüfsicherheit einen wirtschaftlichen Test ermöglicht. Insbesondere ist die Prüfung nach dem erfindungsgemäßen Verfahren in sehr kurzer Prüfzeit durchführbar.

Diese Aufgabe wird erfindungsgemäß dadurch gelöst, daß die Leiteranordnung mit einem inhomogenen elektrischen Feld beaufschlagt wird und mindestens ein aufgrund des inhomogenen elektrischen Feldes sich bildendes elektrisches Potential von den Meßsonden an den einzelnen Prüfpunkten abgenommen und mit dem Potential anderer Prüfpunkte und/oder mit einer Referenz verglichen wird. Erfindungsgemäß ist also vorgesehen, daß durch das Einbringen der Leiteranordnung in das inhomogene elektrische Feld aufgrund der Feldstärke an der Leiteranordnung ein inhomogenes elektrisches Potential erzeugt und mittels der Meßsonden abgegriffen wird. Aufgrund der elektrischen Leitfähigkeit der Leiteranordnung wird das Potential bei durchgehendem Leiterzug an jedem Ort dieses Leiterzuges das gleiche sein. Liegt beispielsweise eine Unterbrechung des Leiterzuges vor, so stellen sich an beiden Leiterzugteilen unterschiedliche Potentiale ein, die dann mittels der Meßsonden abgegriffen und bei der Auswertung als entsprechend unterschiedlich erkannt werden, was den Rückschluß auf die erwähnte Leitungsunterbrechung zuläßt. Andererseits weisen isoliert voneinander verlaufende Leiteranordnungen, zum Beispiel voneinander isolierte Leiterbahnen einer Leiterplatte, aufgrund der Inhomogenität des elektrischen Feldes unterschiedliche Potentiale auf, was den Schluß zuläßt, daß es sich daher um voneinander isolierte Leiterzüge handeln muß. Anhand gespeicherter Referenzwerte, die mit den einzelnen Prüfergebnissen verglichen werden, läßt sich somit eine Aussage über die Funktionfähigkeit des Prüflings treffen. Die erwähnte Inhomogenität des elektrischen Feldes ist derart zu verstehen, daß sichergestellt ist, daß bei einem intakten Prüfling das Potential jeder dort vorhandenen Leiteranordnung/Leiterbahn gegenüber den anderen isolierten Leiteranordnungen bzw. Leiterbahnen ein anderes ist, so daß eine klare Aussage möglich ist. Hätten getrennt, also isoliert, voneinander liegende Leiteranordnungen das gleiche Potential (zum Beispiel aufgrund einer entsprechenden Feldstärkeverteilung), so kann nicht unterschieden werden, ob diese Leiteranordnungen einen (unzulässigen) elektrischen Kontakt untereinander haben, oder ob es sich um zwar voneinander isolierte Leiteranordnungen handelt, die doch (zufällig) das gleiche Potential angenommen haben.

Um festzustellen, ob ein zusammenhängender Leiterzug des Prüflings eine unzulässige Unterbrechung aufweist, ist es erforderlich, einzelne Prüfpunkte (zum Beispiel Anschlußpunkte von später auf die Leiterplatte aufzulötenden elektrischen Bauelementen) mit den erwähnten Meßsonden zu kontaktieren. Wird an allen Prüfpunkten das gleiche Potential festgestellt, so ist keine Unterbrechung vorhanden. Dieses (gleiche) Potential wird in einer Auswerteeinrichtung gespeichert. Sofern alle Leiterzüge auf diese Art und Weise geprüft sind, kann der Test auf unzulässige Kurzschlüsse zwischen diesen Leiterzügen dadurch erfolgen, daß die gespeicherten Meßwerte miteinander verglichen werden. Es ist also nicht erforderlich, daß jeder Leiterzug gegenüber jedem anderen Leiterzug für eine derartige Prüfung mit einer Meßsonde angefahren werden muß. Stellt sich bei dieser "rechnerischen Prüfung" heraus, daß grundsätzlich unterschiedliche Potentiale vorliegen, so ist sichergestellt, daß zwischen den einzelnen Leiterzügen kein unzulässiger Kurzschluß vorliegt. Sollten dennoch einmal zum Beispiel zwei Leiterzüge mit gleichem Potential aufgefunden werden, so kann dies zwei Ursachen haben: Entweder liegt ein unzulässiger Kurzschluß vor oder -aufgrund der individuellen Feldverteilung und der individuellen Ausbildung des Prüflings- hat sich auf beiden Leiterzügen zufällig das gleiche Potential ergeben, das heißt, das elektrische Feld hat nicht die eingangs erwähnte erwünschte inhomogene Verteilung. Um hier Abhilfe zu schaffen kann entweder eine Feldkorrektur vorgenommen werden, so daß sich auch bei diesen beiden Leiterzügen unterschiedliche Potentiale einstellen oder es ist -wie im Stand der Technik- bei diesen beiden Leiterzügen eine Prüfung durch Bildung einer Meßschleife mittels zweier Meßsonden möglich, einen Kurzschluß oder eine Unterbrechung zu erkennen.

Durch die Erfindung braucht nicht jeder Leiterzug gegenüber jedem Leiterzug für die erwähnte Prüfung mit den Meßsonden angefahren werden, sondern es wird ein rechnerischer Vergleich der gespeicherten Werte vorgenommen, so daß die Meßzeit erheblich verkürzt wird.

Nach einer Weiterbildung der Erfindung ist vorgesehen, daß das elektrische Feld mittels einer Elektrodenanordnung erzeugt wird. Hierbei kann es sich beispielsweise um in einer Ebene angeordnete Einzelelektroden handeln, an der unterschiedliche Spannungen liegen, so daß sich oberhalb der Gesamtanordnung der Einzelelektroden das gewünschte inhomogene, elektrische Feld ausbildet.

Die Erfindung betrifft ferner ein Verfahren zu Prüfung einer elektrischen Leiteranordnung auf Kurzschluß und/oder Unterbrechung, wobei mindestens ein Prüfpunkt der Leiteranordnung mit elektrischer Spannung derart zum Aufbau eines inhomogenen elektrischen Feldes beaufschlagt wird, daß aufgrund seiner Feldstärke an einer Elektrodenanordnung mindestens ein elektrisches Potential erzeugt, erfaßt und ausgewertet wird. Insofern handelt es sich also um eine Umkehrung gegenüber dem vorstehend erwähnten Verfahren, da nun der Prüfling über die Meßsonden mit einer bzw. mehreren elektrischen Spannungen zum Aufbau des elektrischen Feldes beaufschlagt wird und die sich aufgrund der Feldverteilung ergebenen Potentiale von einer Elektrodenanordnung erfaßt werden. Im zuvor erwähnten Verfahren wird das elektrische Feld also von einer Elektrodenanordnung (Antennenanordnung) der Meßeinrichtung erzeugt, während bei dem nunmehr beschriebenen Verfahren die Leiteranordnung (Leiterbahnen oder dergleichen) die Antennenanordnung für die Erzeugung des elektrischen Feldes bilden. Bei der zuletzt beschriebenen Ausgestaltung stellt sich an der Elektrodenanordnung eine bestimmte Potentialverteilung ein, die sich ändert, sobald der Prüfling nicht intakt ist, das heißt also, Kurzschlüsse oder Unterbrechungen aufweist. Das Abweichen von einer vorgegebenen Potentialverteilung, die einen intakten Prüfling kennzeichnet, ergibt somit die Möglichkeit, Fehler zu erkennen. Nach einer Weiterbildung der Erfindung ist vorgesehen, daß die Auswertung durch Vergleich mit Bezugsgrößen erfolgt. Dies wurde vorstehend schon erwähnt; die Referenzwerte bilden die genannten Bezugsgrößen.

Ferner sind vorzugsweise mit der Leiteranordnung in Kontakt bringbare Verbindungsmittel zur Zu- und Abführung von Prüfströmen vorgesehen. Neben der erwähnten elektrostatischen Prüfung können die einzelnen Leiteranordnungen somit auch mit Prüfströmen beaufschlagt werden, um beispielsweise die Stromfestigkeit zu prüfen. Insofern entspricht dieses weitere Prüfverfahren der aus dem Stand der Technik bekannten Prüfung. Stets ist zur Erzeugung einer Prüfschleife ein Abschnitt einer Leiteranordnung mit mindestens zwei Meßsonden zu kontaktieren, um den Prüfstrom einzuspeisen bzw. abzuführen.

Besonders vorteilhaft ist es, wenn die Meßsonden die Verbindungsmittel bilden. Die Meßsonden haben dann also eine Doppelfunktion, indem sie entweder zur Abnahme des Potentials bzw. für die Zuführung der Spannung zum Aufbau des elektrischen Feldes eingesetzt werden oder -bei der erwähnten Stromprüfung- der Zu- und Abführung des Prüfstromes dienen.

Ferner ist vorzugsweise vorgesehen, daß eine Meßsonde oder mehrere Meßsonden verwendet werden, die als geteilte Meßsonden ausgebildet sind. Dies bedeutet, daß sie eine zweiteilige Meßspitze mit voneinander elektrisch isolierten, nebeneinander angeordneten Spitzenbereichen aufweisen. Beim Kontaktieren des Prüflings treten beide Spitzenbereiche in elektrischen Kontakt mit der Leiteranordnung, sofern eine einwandfreie Funktion vorliegt. Nach einer bevorzugten Ausführungsform ist die Meßsonde längsgeteilt, wobei sich zwischen den beiden Hälften eine Isolierschicht befindet. Mit einer derartig geteilten Meßsonde kann eine Vier-Drahtmessung (Guarding) durchgeführt werden. Ferner ist es möglich, eine Prüfung von Fehlkontaktierungen, schlechten Kontaktierungen, eine Prüfung der Positioniergenauigkeit der geteilten Meßsonde in bezug auf einen Prüfpunkt der Leiteranordnung und/oder eine Prüfung der Prüflingsposition relativ zur Testvorrichtung vorzunehmen. Hierzu wird ein Teststromkreis zwischen den beiden Spitzenbereichen der geteilten Meßsonde erzeugt. Dies erfolgt unabhängig von der eigentlichen Prüfung der Leiteranordnung des Prüflings. Der Teststrom fließt dabei über die beiden Kontaktstellen der beiden Spitzenbereiche und auch über einen Leiterbereich des jeweiligen Prüfpunktes beziehungsweise der jeweils kontaktierten Stelle der Leiteranordnung. Bildet sich ein einwandfreier Teststrom aus, so liegt eine einwandfreie Kontaktierung vor. Entspricht der Teststrom nicht einem Referenzwert, so ist von einer Fehlkontaktierung (zum Beispiel mit erhöhtem Übergangswiderstand) auszugehen. Bildet sich kein Teststrom aus, so liegt eine Unterbrechung vor. Dies kann bedeuten, daß die Meßsonde nicht einwandfrei mit der Leiteranordnung in Kontakt steht oder daß sich ein Übergangswiderstand ausgebildet hat. Überdies ist es auch möglich, daß die Meßsonde nicht einwandrei relativ zum Prüfpunkt auf den Prüfling aufgesetzt worden ist beziehungsweise daß der Prüfling nicht seine Normlage einnimmt, sondern dejustiert ist.

Zur Feststellung der genannten Dejustage und zur Herbeiführung einer einwandfreien Positionierung durch Positionskorrektur des Prüflings läßt sich die geteilte Meßsonde insofern also auch benutzen. Sie wird auf die Leiteranordnung aufgesetzt und anschließend wird der Teststromkreis aktiviert. Liegt eine Unterbrechung des Teststromkreises vor, so erfolgt solange eine Positionskorrektur, bis der Teststrom einwandfrei fließt. Dies bedeutet, daß nunmehr der Prüfling der gewünschte Lage einnimmt, in der die Meßsonde einwandfrei mittig zum Beispiel auf einer Leiterbahn des Prüflings aufliegt. Unterstellt wird hierbei, daß die Meßsonde relativ zu den übrigen Teilen der Testanordnung ihre Soll-Position innehat. Vorzugsweise wird eine derartige Prüfung in verschiedenen Bereichen der Leiteranordnung, beispielsweise in mehreren Ecken einer zu prüfenden Leiterplatte, vorgenommen.

Die Positionierung des Prüflings kann alternativ oder zusätzlich auch durch optischen Vergleich mit einer Referenzanordnung, nämlich einem Referenzprüfling, durchgeführt werden. Dieser kann insbesondere als transparente Referenzplatte ausgebildet sein.

Besonders vorteilhaft ist es, wenn bei der Prüfung eine Kapazitätsbestimmung durch Ermittlung des der Leiteranordnung bzw. jeder Leiterbahn zufließenden Stromes erfolgt. Bei diesem Strom handelt es sich -bei einem zeitlich konstanten elektrischen Feldquasium den Ladestrom der vorliegenden Kapazitätsanordnung, deren Platten zum einen von der jeweiligen Leiteranordnung und zum anderen von den Elektroden zum Aufbau des elektrischen Feldes gebildet wird. Sofern allerdings kein zeitlich konstantes elektrisches Feld, sondern ein Wechselfeld eingesetzt wird, ergibt sich nicht nur ein Ladestrom, sondern aufgrund der gebildeten Kapazitäten ein Dauerstrom, der ermittelt werden kann und die Kapazitätsbestimmung zuläßt. Auch hier ist es -wie vorstehend bereits erwähnt- möglich, die bestimmten Kapazitätswerte mit Referenzkapazitäten zu vergleichen, so daß eine Aussage über die Funktionsfähigkeit des Prüflings möglich ist.

Nach einem besonderen Ausführungsbeispiel ist vorgesehen, daß die Elektroden der das elektrische Feld bildenden Elektrodenanordnung umschaltbar an elektrische Spannungen zum Aufbau des inhomogenen Feldes anschließbar sind. In Abhängigkeit von der Auswahl, welche Elektroden mit welchen elektrischen Spannungen verbunden werden, läßt sich das elektrische Feld beeinflussen. Dabei ist stets anzustreben, daß sich die gewünschte Inhomogenität einstellt, so daß eindeutige Meßergebnisse erzielt werden können.

Die Erfindung betrifft ferner eine Vorrichtung zur Prüfung einer elektrischen Leiteranordnung, insbesondere von Leiterbahnen einer Leiterplatte, auf Kurzschluß und/oder Unterbrechung, mit Meßsonden, die mit Prüfpunkten der Leiteranordnung kontaktierbar sind und mit einer Auswerteeinrichtung, wobei eine Elektrodenanordnung zum Aufbau eines inhomogenen elektrischen Feldes vorgesehen ist, daß die Leiteranordnung beaufschlagt und dort aufgrund der elektrischen Feldstärke ein elektrisches Potential erzeugt, das mittels der Meßsonden der Auswerteeinrichtung zugeleitet wird.

Vorzugsweise kann vorgesehen sein, daß die Elektrodenanordnung eine Vielzahl von Elektroden aufweist, an die entsprechende Spannungen eines Generators zum Aufbau des inhomogenen elektrischen Feldes angelegt sind.

Alternativ ist es auch möglich, daß die Elektroden von Leitern, insbesondere Streifenleitern, einer Folie oder dergleichen gebildet ist, wobei die Folie der Leiteranordnung zur Prüfung zugeordnet wird. Diese Zuordnung kann vorzugsweise durch Unterdruck erfolgen, das heißt, die Folie wird aufgrund eines Vakuums am Prüfling gehalten. Für eine Kontaktierung wird die Folie von den Meßsonden durchstoßen, so daß der elektrische Kontakt zu der Leiteranordnung möglich ist.

Nach einem weiteren Ausführungsbeispiel der Erfindung ist vorgesehen, daß die Elektroden von Drähten gebildet sind, die voneinander isoliert eine Prüfebene überspannen, welche der Aufnahme eines die Leiteranordnung aufweisenden Prüflings dient.

Die Vorrichtung zeichnet sich vorzugsweise dadurch aus, daß die Umschaltung der Elektroden der Elektrodenanordnung mittels eines Multiplexers erfolgt. Der Multiplexer wird vorzugsweise von der Auswerteeinheit zur Umschaltung angesteuert. Durch die Umschaltung können bestimmte Elektroden der Elektrodenanordnung an bestimmte Spannungen angelegt werden, wodurch sich das gewünschte elektrische Feld mit der entsprechenden Inhomogenität einstellt.

Nach einer weiteren Ausführungsform der Erfindung ist vorgesehen, daß ein erster Bereich der Leiteranordnung des Prüflings die Elektrodenanordnung bildet und daß mit dem damit gebildeten elektrischen Feld ein zweiter Bereich der Leiteranordnung des Prüflings geprüft wird. Dieses Vorgehen führt also dazu, daß mittels eines Bereichs der Leiteranordnung, beispielsweise mit einer Anzahl von Netzen des Prüflings, das elektrische Feld selbst gebildet wird. Die verbleibenden elektrischen Netze des Prüflings können dann mit dem auf diese Art und Weise gebildeten elektrischen Feld geprüft werden. Ist die Prüfung des zweiten Bereichs der Leiteranordnung erfolgt, so wird dieser oder ein gewünschter anderer Bereich für den Feldaufbau verwendet und der Bereich (erster Bereich oder ein Teil davon) der Leiteranordnung, der zuvor für die Felderzeugung verwendet worden ist, wird nunmehr einer Prüfung unterzogen.

Nach einer weiteren bevorzugten Ausführungsform weist der Prüfling selbst eine Elektrodenanordnung für die Prüfung seiner Leiteranordnung auf. Gegenüber dem vorherigen Ausführungsbeispiel wird also nicht ein Teil seiner Leiteranordnung für den Feldaufbau verwendet, sondern es ist eine separate Elektrodenanordnung vorgesehen. Diese kann insbesondere von mindestens einer Leiterschicht einer Multilayer-Platine gebildet sein, wobei mindestens eine andere Leiterschicht die zu prüfende Leiteranordnung bildet. Mithin besteht der Prüfling aus einer Multilayer-Platine, wobei einige Schichten die Nutzschaltung, also die Leiteranordnung bilden und mindestens eine andere Schicht oder Teile einer anderen Schicht für den elektrischen Feldaufbau herangezogen wird.

Die Zeichnung veranschaulichen die Erfindung anhand von Ausführungsbeispielen. Und zwar zeigt:

Figur 1 ein Blockschaltbild der Vorrichtung zur Prüfung einer elektrischen Leiteranordnung,

Figur 2 ein Flußdiagramm des Arbeitsalgorithmus' der Vorrichtung,

Figur 3 ein Flußdiagramm des Meßzyklus-Algorithmus' der Vorrichtung,

Figur 4 ein Flußdiagramm des Algorithmus' der Meßergebnis-Analyse,

Figur 5 ein Blockschaltbild eines weiteren Ausführungsbeispiels der Vorrichtung,

Figur 6 eine Draufsicht auf einen mittels einer Elektrodenanordnung beaufschlagten Bereich eines Prüflings in schematischer Darstellung,

Figur 7 eine Breitseitenansicht einer Meßsonde,

Figur 8 eine Schmalseitenansicht der Meßsonde gemäß Figur 7,

Figur 9 eine geteilte Meßsonde in Breitseitenansicht und

Figur 10 eine Schmalseitenansicht der Meßsonde gemäß Figur 9.

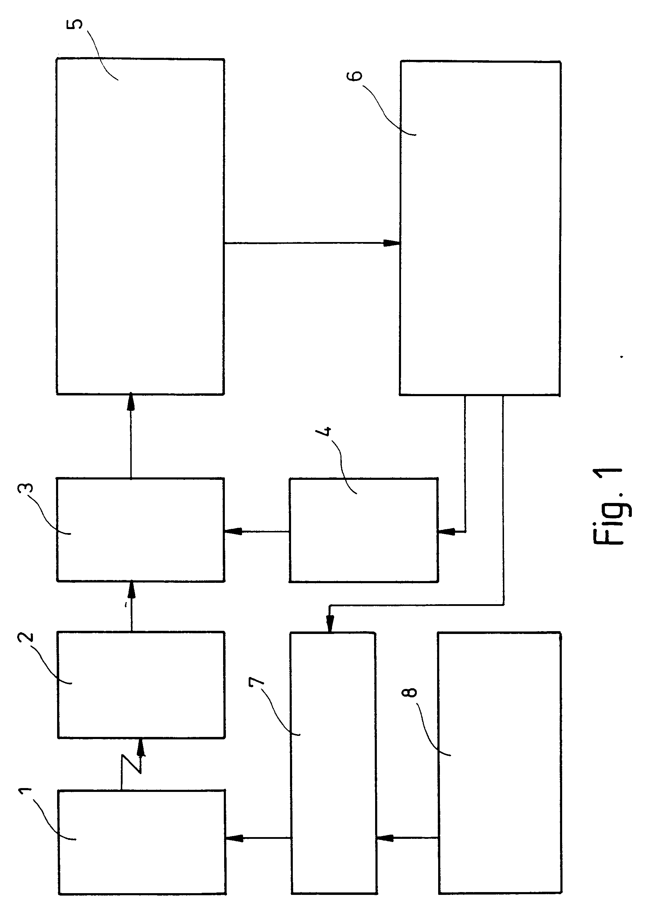

Die Figur 1 zeigt das Blockschaltbild eines ersten Ausführungsbeispiels einer Vorrichtung zur Prüfung einer elektrischen Leiteranordnung. Die Vorrichtung weist eine Elektrodenanordnung 1 auf, die dem Aufbau eines inhomogenen elektrischen Feldes dient. Diese Elektrodenanordnung 1 kann auch als "Antennenanordnung" bezeichnet werden. Sie wirkt auf einen Prüfling 2, wobei diese Wirkung in der Figur 1 durch den Blitzpfeil verdeutlicht wird. Mithin ist der Prüfling 2 dem von der Elektrodenanordnung 1 erzeugten elektrischen Feld ausgesetzt. Der Prüfling 2 weist eine Leiteranordnung auf, die beispielsweise von Leiterbahnen einer Leiterplatte gebildet ist. Ziel ist es, diese Leiteranordnung auf Fehler im Hinblick auf einen Kurzschluß und/oder eine Unterbrechung zu untersuchen.

Mittels Meßsonden 3, die mit einer mechanischen Vorrichtung 4 positionierbar sind, lassen sich Prüfpunkte der einzelnen Leiter der Leiteranordnung des Prüflings kontaktieren, so daß das sich jeweils aufgrund des elektrischen Feldes am Leiter bildende elektrische Potential abgenommen werden kann. Diese Meßgröße wird einem mit Analog/Digital-Wandler (A/D-Wandler) versehenen Meßkanal 5 zugeführt. Der Meßkanal 5 ist mit einer Auswerteeinrichtung 6 verbunden. Die Auswerteeinrichtung 6 führt einerseits die Prüfung durch Auswertung der Meßergebnisse und gegebenenfalls einen Vergleich der Meßergebnisse mit Referenzwerten durch und steuert andererseits die mechanische Vorrichtung 4 und einem Multiplexer 7 an. Der Multiplexer 7 ist mit einem Generator 8 verbunden, der entsprechende elektrische Spannungen zum Aufbau des elektrischen Feldes liefert. Diese Spannungen werden über den Multiplexer 7 den einzelnen Elektroden der Elektrodenanordnung 1 zugeführt.

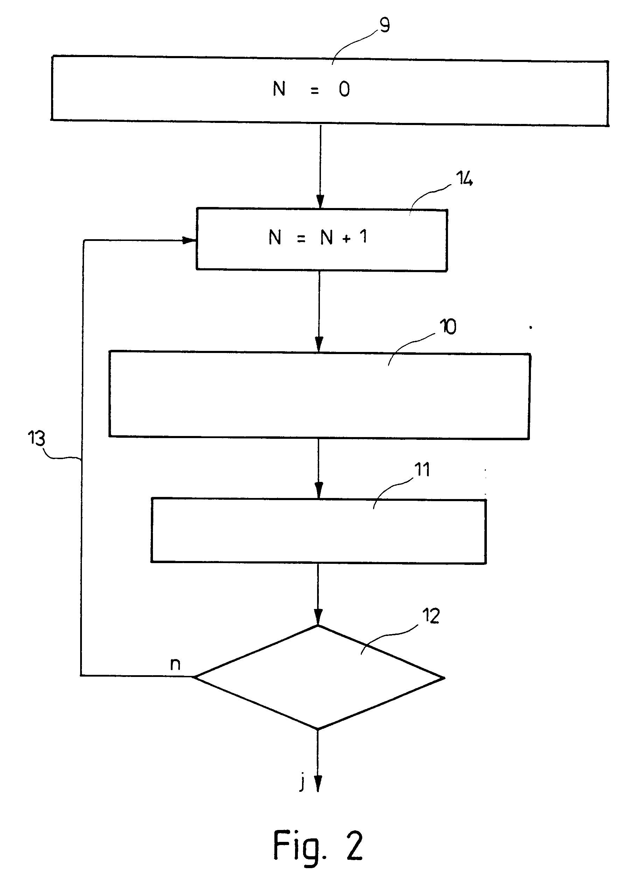

Für die Prüfung der Leiteranordnung wird diese in das elektrische Feld der Elektrodenanordnung eingebracht. Gemäß Figur 2 sind eine gewünschte Anzahl von Prüfpunkten der Leiteranordnung vorgesehen, die mit den Meßsonden 3 nacheinander kontaktiert werden. Vorzugsweise sind mehrere Meßsonden 3 vorgesehen, die zum Beispiel in X,Y und Z-Richtung eines kartesischen Koordinatensystems verfahren werden können. Der aktuell anzufahrende Prüfpunkt N ist im Flußdiagramm der Figur 2 mit dem Schritt 14 gekennzeichnet. Im Schritt 10 erfolgt die Positionierung der entsprechenden Meßsonde 3 in bezug auf den Prüfpunkt N und die Kontaktierung dieses Meßpunktes.

Im Schritt 11 wird dann der Meßzyklus durchgeführt. Dies bedeutet, daß das Potential im Prüfpunkt des entsprechenden Leiters der Leiteranordnung ermittelt und über den Meßkanal 5 der Auswerteeinrichtung 6 zugeführt wird. Im Schritt 12 wird geprüft, ob alle vorgesehenen Prüfpunkte kontaktiert worden sind. Ist dies nicht der Fall (n) so wird die Schleife 13 erneut durchlaufen und man gelangt über den Schritt 14 zum Schritt 10. Im Schritt 14 wird also weitergezählt. Es gilt daher die Beziehung:

$$N = N + 1.$$

Sind alle Prüfpunkte aller Leiter kontaktiert, so endet der Schritt 12 im Zweig "j", das heißt, der Arbeitsalgorithmus der Vorrichtung ist beendet.

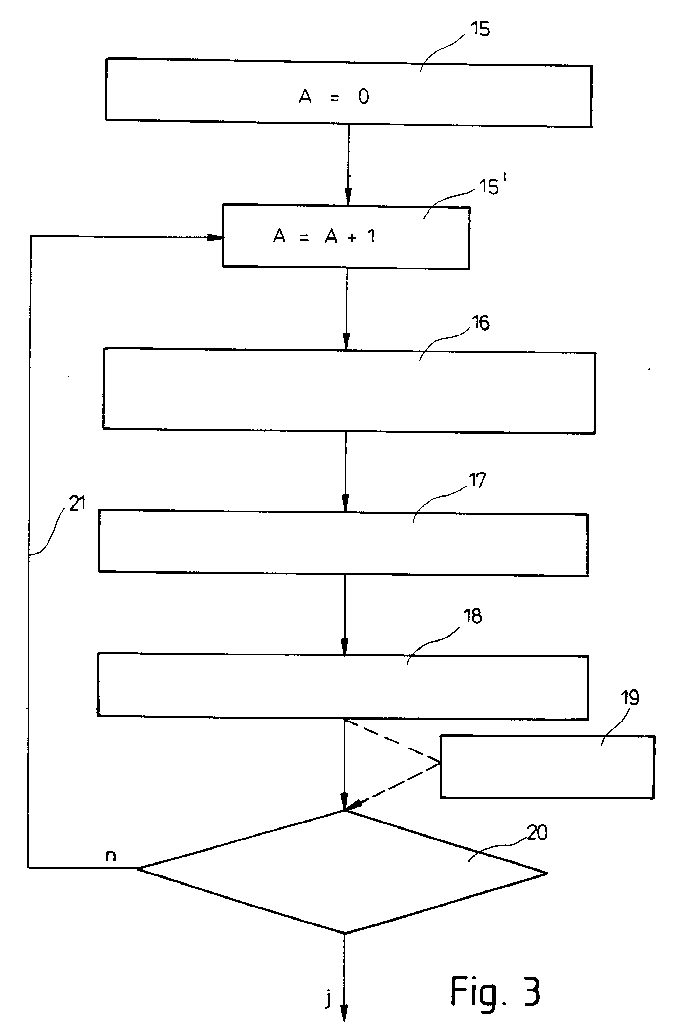

Das Flußdiagramm der Figur 3 verdeutlicht den Meßzyklus-Algorithmus der Vorrichtung. Im Schritt 15, 15' wird ein bestimmter Antennensatz A ausgewählt. Unter Antennensatz A sind bestimmte Elektroden der Elektrodenanordnung 1 zu verstehen, die zum Aufbau des elektrischen Feldes mit Spannungen beaufschlagt werden. Die Auswahl der Elektroden erfolgt durch den Multiplexer 7 gemäß Schritt 16. Im Schritt 17 schaltet der Multiplexer 7 die vom Generator 8 gelieferten elektrischen Spannungen durch, so daß sie an den einzelnen Elektroden der Elektrodenanordnung 1 anliegen. Im nachfolgenden Schritt 18 wird dann die Potentialmessung an den einzelnen Prüfpunkten der Leiteranordnung durchgeführt. Wenn es notwendig ist, kann in bestimmten Fällen die Kapazität des Netzes ermittelt werden. Dies erfolgt im Schritt 19 durch Ermittlung des Stroms. Im Schritt 20 wird geprüft, ob die gewünschte Anzahl von Elektrodenkonfigurationen (Antennensätzen) erreicht ist. Ist dies nicht der Fall (n), so wird über die Schleife 21 der Schritt 16 erneut angefahren. Folglich gilt in der Schleife 21 die Beziehung:

$$A = A + 1.$$

Sind alle Antennensätze realisiert worden, so endet der Schritt 20 mit "j".

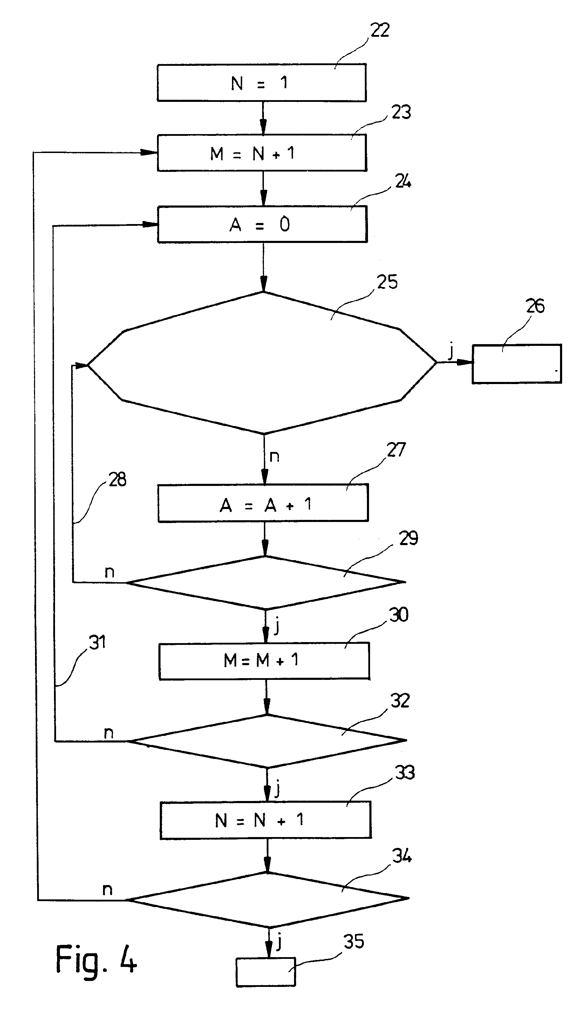

Die Figur 4 verdeutlicht den Algorithmus der Meßergebnis-Analyse. Mit N, M sind die aktuell angefahrenen Prüfpunkte der Leiteranordnung bezeichnet (Schritte 22,23), wobei gilt

$$M = N + 1.$$

Mit A sind die Antennensätze (die jeweils angesteuerten Elektroden der Elektrodenanordnung 1) gekennzeichnet (Schritt 24). In zwei Fällen gelangt der Algorithmus über Schritt 25 zum Schritt 26 (das heißt, Fehler in der Leiterplatte):

1. Wenn die Prüfpunkte N und M zu einem Netz gehören und unterschiedliche Potentiale aufweisen.
2. Wenn die Prüfpunkte N und M zu verschiedenen Netzen gehören und für alle Antennensätze gleiche Potentiale aufweisen.

Im ersten Fall liegt eine Unterbrechung im Netz vor; im zweiten Fall besteht ein Kurzschluß zwischen den beiden Netzen.

Im Schritt 25 gilt die Beziehung

$$| U (N, A) - U (M, A) | > \Delta U.$$

Dabei stellt U das Potential und $\Delta$ U eine Potentialdifferenz dar, die im Bereich eines möglichen Meßfehlers liegen darf. Ist also die in der vorstehenden Beziehung angeführte Differenz der Potentiale größer als ein vorbestimmter Meßfehler, so liegt ein Fehler bei dem Prüfling vor (j). Im Schritt 26 erfolgt dann die Fehlermeldung. Ist die ermittelte Differenz kleiner als der Meßfehler (n) so wird zum Schritt 27 übergegangen, in dem der vorstehend beschriebene Vorgang mit einem weiteren Antennensatz (A + 1) nochmals durchgeführt wird. Die Anzahl der Antennensätze A wird vorgegeben; ist sie erreicht, so wird die Schleife 28 verlassen und vom Schritt 29 zum Schritt 30 übergegangen. Im Schritt 30 wird ein weiterer Prüfpunkt des Netzes ausgewählt und -entsprechend Schleife 31- erneut die Variation der Antennensätze durchgeführt. Sind gemäß Schritt 32 sämtliche Prüfpunkte untersucht worden, so wird über die Schritte 33 und 34 zum nächsten Prüfpunkt übergegangen und dort die entsprechende Prüfung ebenfalls vorgenommen. Ist der gesamte Prüfling geprüft, so wird das Programm beendet (Schritt 35).

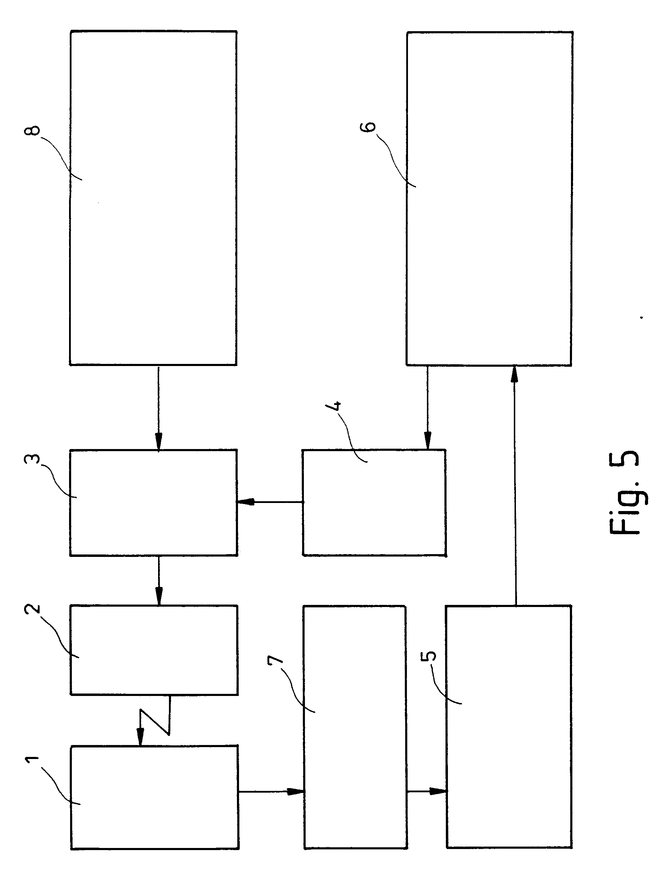

Die Figur 5 zeigt ein weiteres Ausführungsbeispiel der Vorrichtung. Dieses Ausführungsbeispiel arbeitet "umgekehrt" zum Ausführungsbeispiel der Figur 1, indem die Leiteranordnung des Prüflings 2 als Antennenanordnung verwendet und an einer Elektrodenanordnung 1 das vom Prüfling erzeugte elektrische Feld zur Auswertung abgenommen wird. Dementsprechend beaufschlagt der Generator 8 die einzelnen Meßsonden 3, die die Spannungen des Generators 8 an die Leiteranordnung des Prüflings 2 übertragen. Das so gebildete elektrische Feld beaufschlagt die Elektrodenanordnung 1, deren einzelne Elektroden über den Multiplexer 7 und den Meßkanal 5 mit der Auswerteeinrichtung 6 verbunden sind. Die Auswerteeinrichtung 6 steuert ferner die mechanische Vorrichtung 4 für die Positionierung der Meßsonden 3 an.

Der Meßvorgang des Ausführungsbeispiels der Figur 5 erfolgt in entsprechender Weise wie der beim Ausführungsbeispiel der Figur 1.

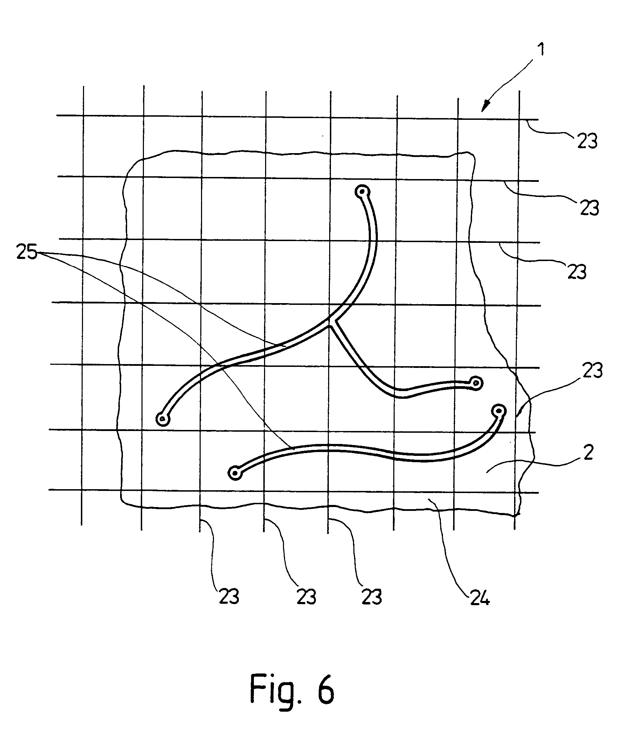

Die Figur 6 verdeutlicht ein Ausführungsbeispiel einer Elektrodenanordnung 1, die aus gitterförmig angeordneten Drahtelektroden 23 besteht, wobei die einzelnen parallelen bzw. sich kreuzenden Drahtelektroden 23 voneinander elektrisch isoliert sind. Mittels des Multiplexers 7 können bestimmte Elektroden ausgewählt und mit gewünschten Spannungen des Generators 8 verbunden werden. In der Figur 6 ist ferner ein Abschnitt eines Prüflings 2 dargestellt, der als Leiterplatte 24 ausgebildet ist und Leiterbahnen 25 trägt, die die Leiteranordnung bilden. Zum Aufbau des elektrischen Feldes werden an entsprechende Drahtelektroden 23 gewünschte Spannungen des Generators 8 angelegt (Ausführungsbeispiel der Figur 1). Alternativ ist es auch möglich, an die Leiterbahnen 25 entsprechende Spannungen des Generators 8 anzulegen, so daß das hierdurch gebildete elektrische Feld mit den Drahtelektroden 23 zusammenwirkt und an diesen Drahtelektroden 23 entsprechende Potentiale erzeugt (Ausführungsbeispiel der Figur 5).

EP 0 508 062 B1

Gemäß einem nicht dargestellten Ausführungsbeispiel der Erfindung kann die Elektrodenanordnung 1 mittels einer Folie mit eingebetteten leitenden Streifen oder dergleichen ausgebildet sein. Diese Folie kann einseitig oder auch beidseitig am Prüfling (zum Beispiel Leiterplatte) angeordnet oder vorzugsweise mittels Vakuum angesaugt werden. Dieses Ansaugen hat den Vorteil, daß durch die Kontaktkräfte der einzusetzenden Meßsonden eine Verbiegung der Leiterplatte erfolgen kann, wobei die Folie beziehungsweise die Folien diese Verbiegung/Durchbiegung mitmachen, so daß sich keine Feldveränderungen ergeben. Die Kontaktierung der Meßsonden erfolgt dann dadurch, daß die Spitzen der Meßsonden die Folie durchstechen und in Kontakt zu den Leiterbahnen des Prüflings treten.

Nach einem anderen Ausführungsbeispiel können auch einige Netze des Prüflings selber herangezogen werden, um das inhomogene elektrische Feld aufzubauen. Es werden dann aktuell stets die Netze des Prüflings zum Aufbau des elektrischen Feldes herangezogen, die momentan nicht geprüft werden. Im sich anschließenden Meßzyklus kann dann zum Beispiel eine Umkehrung erfolgen, das heißt, die Netze, die vorher zur Feldbildung herangezogen wurden, sind zu prüfen, wobei die Beaufschlagung mit dem elektrischen Feld durch Netze erfolgt, die zuvor der Prüfung unterzogen worden sind.

Nach einer weiteren Variante ist es ebenfalls möglich, daß der Prüfling selbst die Elektrodenanordnung aufweist, die zur Bildung des elektrischen Feldes notwendig ist. Hierzu ist -im Gegensatz zum vorstehenden Ausführungsbeispiel- jedoch eine Trennung zwischen der Elektrodenanordnung und den Leiterbahnen oder dergleichen des Prüflings vorgenommen, indem zum Beispiel bei einer Multilayer-Leiterplatte eine oder mehrere Lagen als Elektrodenanordnung für die Felderzeugung verwendet werden. Andere Lagen bilden quasi den Prüfling selber, das heißt, seine Leiteranordnung.

Nach einem weiteren Ausführungsbeispiel kann ein Rahmen oder dergleichen vorgesehen sein, der räumlich dem Prüfling genähert wird und Schienen oder Stäbe aufweist, die die Elektrodenanordnung zur Erzeugung des elektrischen inhomogenen Feldes bilden. In diesem Falle bleibt hinreichend Freiraum, um die Meßsonden zuführen zu können.

Schließlich ist es auch möglich, eine Leiterplatte oder dergleichen -insbesondere bei einseitigem Testen- mit einer Elektrodenanordnung (entsprechende Leiterbahnanordnung) zu versehen, mit der das elektrische Feld erzeugt wird. Der Prüfling wird für die Prüfung auf diese Leiterplatte aufgelegt oder an diese herangeführt.

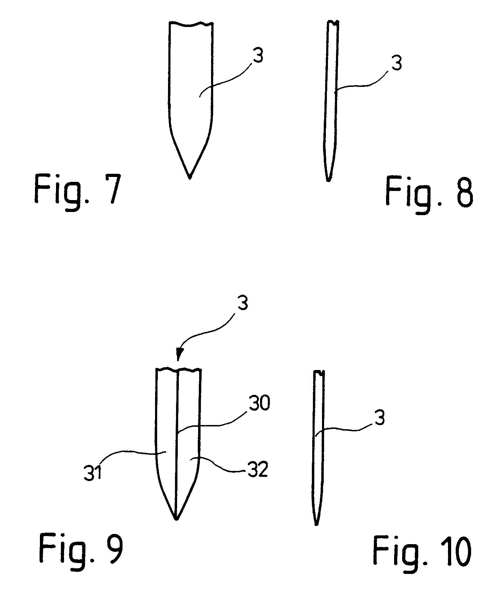

Gemäß der Figur 7 kann als Meßsonde 3 eine messerartige Kontaktspitze verwendet werden. Diese eignet sich besonders gut, um Pads, Bohrungen, Bohrungswände und so weiter zu kontaktieren. Die messerartige Ausbildung bedeutet: sie weist in der Breitseitenansicht gemäß Figur 3 ein größeres Maß als in der Schmalseitenansicht gemäß Figur 8 auf. Die Meßsonde 3 der Figur 7 besitzt eine symmetrisch zulaufende Spitze.

Die Figuren 9 und 10 zeigen eine weitere Ausführungsform einer Meßsonde 3, die jedoch längsgeteilt ist. Dies erfolgt mittels einer Isolierschicht 30. Die durch die Isolierschicht 30 von einander getrennten beiden Hälften 31 und 32 sind jeweils separat elektrisch mit der entsprechenden Prüfeinrichtung verbunden. Diese "gespaltene" Anordnung mit zwei isolierten Spitzenbereichen ermöglicht auf einfache Weise eine Vier-Drahtmessung (Guarding). Ferner ist es möglich, die Kontaktierung genau zu prüfen. Fehlkontaktierungen oder schlechte Kontaktierungen (Übergangswiderstand) werden auf einfache Weise erkannt. Dies ist zum Beispiel möglich, wenn während der Prüfung ein Teststromkreis zwischen den beiden Hälften 31 und 32 erzeugt wird. Ist der Stromfluß einwandfrei, so ist die Kontaktierung in Ordnung. Führt der Stromfluß zu Erkennung eines hohen Übergangswiderstandes beziehungsweise liegt gar kein Stromfluß vor, so ist die Kontaktierung mangelhaft oder gestört.

Die Positionierung des Prüflings kann auf unterschiedliche Weise erfolgen. Einerseits ist es möglich, eine Grob-/Feinkalibrierung mittels einer Referenzplatte vorzunehmen. Die Referenzplatte stellt somit einen Referenzprüfling dar. Als weitere Möglichkeit bietet sich eine optische Prüfung der Positionierung des entsprechenden Prüflings an. Diese kann insbesondere dadurch erfolgen, daß mittels einer Kamera oder dergleichen die Position des Prüflings mit einer Sollposition verglichen wird. Durch die Kamera lassen sich bestimmte Muster der Leiterbahnen des Prüflings auf einfache Weise auffinden. Diese "Leitungsmuster" sind durch das Layout bekannt (zum Beispiel kann ein Vergleich mit CAD-Daten erfolgen). Schließlich besteht auch eine elektromechanische Möglichkeit, die Positionierung des Prüflings zu überwachen. Dies kann mittels der gespaltenen Meßsonden 3 gemäß der Figuren 9 und 10 dadurch erfolgen, daß diese Meßsonden auf bestimmte Pads aufsetzen, wobei durch Stromfluß durch die entsprechenden Hälften der Meßsonden 3 die Position überprüft wird. Liegt der Stromfluß vor, so befindet sich die Meßsonde 3 auf einer Leiterbahn; liegt kein Stromfluß vor, so ist die Meßsonde seitlich zur Leiterbahn versetzt, das heißt, sie befindet sich auf der Isolierschicht. Eine derartige Prüfung kann zum Beispiel in verschiedenen Bereichen (zum Beispiel in zwei oder drei Eckpunkten des Prüflings) erfolgen, wodurch eine einwandfreie oder fehlerhafte Lage des Prüflings zur Sollposition feststellbar ist.

7

**Patentansprüche**

1. Verfahren zur Prüfung einer elektrischen Leiteranordnung, insbesondere von Leiterbahnen einer Leiterplatte, auf Kurzschluß und/oder Unterbrechung, wobei Meßergebnisse von Prüfpunkten der Leiteranordnung ermittelt und ausgewertet werden, **dadurch gekennzeichnet**, daß die Leiteranordnung mit einem inhomogenen elektrischen Feld beaufschlagt wird und daß mindestens ein aufgrund des inhomogenen elektrischen Feldes sich bildendes elektrisches Potential von den Meßsonden (3) an den einzelnen Prüfpunkten abgenommen und mit dem Potential anderer Prüfpunkte und/oder mit einer Referenz verglichen wird.

2. Verfahren nach Anspruch 1, **dadurch gekennzeichnet**, daß das elektrische Feld mittels einer Elektrodenanordnung (1) erzeugt wird.

3. Verfahren zur Prüfung einer elektrischen Leiteranordnung auf Kurzschluß und/oder Unterbrechung, **dadurch gekennzeichnet**, daß mindestens ein Prüfpunkt der Leiteranordnung mit elektrischer Spannung zum Aufbau eines inhomogenen elektrischen Feldes beaufschlagt wird, das aufgrund seiner Feldstärke an einer Elektrodenanordnung (1) mindestens ein elektrisches Potential erzeugt, welches erfaßt und ausgewertet wird.

4. Verfahren nach Anspruch 3, **dadurch gekennzeichnet**, daß die Auswertung durch Vergleich mit Bezugsgrößen erfolgt.

5. Verfahren nach einem der vorhergehenden Ansprüche, **gekennzeichnet durch** mit der Leiteranordnung in Kontakt bringbare Verbindungsmittel zur Zu- und Abführung von Prüfströmen.

6. Verfahren nach einem der vorhergehenden Ansprüche, **dadurch gekennzeichnet**, daß für die Ermittlung der Meßergebnisse Meßsonden (3) verwendet werden, die die Verbindungsmittel bilden.

7. Verfahren nach einem der vorhergehenden Ansprüche, **dadurch gekennzeichnet**, daß eine Meßsonde (3) oder mehrere Meßsonden (geteilte Meßsonden 3) verwendet werden, die eine mehrteilige, insbesondere zweiteilige Meßspitze mit voneinander elektrisch isolierten, nebeneinander angeordneten Spitzenbereichen (Hälften 31,32) aufweisen.

8. Verfahren nach Anspruch 7, **dadurch gekennzeichnet**, daß die Meßsonde (3) mittels einer Isolierschicht (30) längsgeteilt wird.

9. Verfahren nach einem der vorhergehenden Ansprüche, **dadurch gekennzeichnet**, daß mit der geteilten Meßsonde (3) eine Vierdrahtmessung (Guarding) durchgeführt wird.

10. Verfahren nach einem der vorhergehenden Ansprüche, **dadurch gekennzeichnet**, daß zur Prüfung von Fehlkontaktierungen, schlechten Kontaktierungen, zur Prüfung der Positioniergenauigkeit der geteilten Meßsonde (3) in bezug auf den jeweiligen Prüfpunkt der Leiteranordnung und/oder zur Prüfung der Prüflingsposition relativ zur Testvorrichtung ein Teststromkreis zwischen den beiden Spitzenbereichen erzeugt wird, wobei der Teststrom über die Kontaktstellen der beiden Spitzenbereiche und einen Leiterbereich des jeweiligen Prüfpunkts fließt.

11. Verfahren nach Anspruch 10, **dadurch gekennzeichnet**, daß zur Feststellung einer einwandfreien oder fehlerhaften Positionierung beziehungsweise durch Durchführung einer relativ zur Testanordnung erfolgenden Positionskorrektur des Prüflings mindestens eine geteilte Meßsonde (3) auf die Leiteranordnung aufgesetzt und der Teststromkreis aktiviert wird, und daß im Falle eines unterbrochenen Teststromkreises aufgrund eines seitlichen Versatzes der Meßsonde zum entsprechenden Leiter der Leiteranordnung eine Fehlermeldung und/oder eine Positionskorrektur des Prüflings so lange erfolgt, bis der Teststromkreis einwandfrei fließt.

12. Verfahren nach Anspruch 11, **dadurch gekennzeichnet**, daß mehrere unterschiedliche Bereiche der Leiteranordnung mit einer geteilten Meßsonde (3) beaufschlagt werden.

13. Verfahren nach einem der vorhergehenden Ansprüche, **dadurch gekennzeichnet**, daß die Positionierung des Prüflings zur Testanordnung durch optischen Vergleich mit einem Referenzprüfling, insbesondere einer transparenten Referenzplatte, durchgeführt wird.

14. Verfahren nach einem der vorhergehenden Ansprüche, **dadurch gekennzeichnet**, daß die Leiteranordnung mehrere, voneinander isolierte Netze (Leiterzüge) aufweist, daß das Potential für jedes Netz ermittelt und gespeichert wird, und daß die gespeicherten Potentiale miteinander auf rechnerischem Wege, insbesondere mit Hilfe eines Computers, verglichen werden.

15. Verfahren nach einem der vorhergehenden Ansprüche, **dadurch gekennzeichnet**, daß bei zu einem Netz gehörenden Prüfpunkten (N, M) jeweils die Potentiale ermittelt und auf Gleichheit geprüft werden.

16. Verfahren nach einem der vorhergehenden Ansprüche, **dadurch gekennzeichnet**, daß bei nicht zu einem Netz gehörenden Prüfpunkten (N,M) jeweils die Potentiale ermittelt und auf Ungleichheit geprüft werden.

17. Verfahren nach einem der vorhergehenden Ansprüche, **dadurch gekennzeichnet**, daß eine Kapazitätsbestimmung durch Ermittlung des der Leiteranordnung bzw. jeder Leiterbahn zufließenden Stromes erfolgt.

18. Verfahren nach einem der vorhergehenden Ansprüche, **dadurch gekennzeichnet**, daß die bestimmten Kapazitätswerte durch Vergleich mit Referenz-Kapazitätswerten zur Prüfung auf Kurzschluß und/oder Unterbrechung verwendet werden.

19. Verfahren nach einem der vorhergehenden Ansprüche, **dadurch gekennzeichnet**, daß die Elektroden der das elektrische Feld bildenden Elektrodenanordnung (1) umschaltbar an elektrische Spannungen zum Aufbau des inhomogenen Feldes anschließbar sind.

20. Vorrichtung zur Prüfung einer elektrischen Leiteranordnung, insbesondere von Leiterbahnen einer Leiterplatte, auf Kurzschluß und/oder Unterbrechung, mit Meßsonden, die mit Prüfpunkten der Leiteranordnung kontaktierbar sind und mit einer Auswerteeinrichtung, **gekennzeichnet durch** eine Elektrodenanordnung (1) zum Aufbau eines inhomogenen elektrischen Feldes, das die Leiteranordnung beaufschlagt und dort aufgrund der elektrischen Feldstärke ein elektrisches Potential erzeugt, das mittels der Meßsonden (3) der Auswerteeinrichtung (6) zugeleitet wird.

21. Vorrichtung nach Anspruch 20, **dadurch gekennzeichnet**, daß die Elektrodenanordnung (1) eine Vielzahl von Elektroden aufweist, an die entsprechende Spannungen eines Generators (8) zum Aufbau des inhomogenen elektrischen Feldes angeschlossen sind.

22. Vorrichtung nach einem der vorhergehenden Ansprüche, **dadurch gekennzeichnet**, daß die Elektroden von Drähten gebildet sind, die voneinander isoliert eine Prüfebene überspannen, welche der Aufnahme eines die Leiteranordnung aufweisenden Prüflings dient.

23. Vorrichtung nach einem der vorhergehenden Ansprüche, **dadurch gekennzeichnet**, daß die Elektroden von Leitern, insbesondere Streifenleitern, einer Folie oder dergleichen gebildet sind.

24. Vorrichtung nach Anspruch 23, **dadurch gekennzeichnet**, daß die Folie durch Unterdruck am Prüfling gehalten ist.

25. Vorrichtung nach einem der Ansprüche 23 und/oder 24, **dadurch gekennzeichnet**, daß die Meßsonden (3) die Folie zum Kontaktieren des Prüflings durchdringen.

26. Vorrichtung nach einem der vorhergehenden Ansprüche, **gekennzeichnet durch** eine Positioniereinrichtung, mit der die Meßsonden (3) entlang von x- und y-Koordinaten verfahrbar und in z-Richtung zur Kontaktierung der Leiteranordnung bewegbar sind.

27. Vorrichtung nach einem der vorhergehenden Ansprüche, **dadurch gekennzeichnet**, daß die Umschaltung der Elektroden der Elektrodenanordnung (1) mittels eines Multiplexers (7) erfolgt.

28. Vorrichtung nach einem der vorhergehenden Ansprüche, **dadurch gekennzeichnet**, daß der Muliplexer (7) von der Auswerteeinrichtung (6) zur Umschaltung angesteuert wird.

29. Vorrichtung nach einem der vorhergehenden Ansprüche, **dadurch gekennzeichnet**, daß ein erster Bereich der Leiteranordnung des Prüflings die Elektrodenanordnung (1) bildet und daß mit dem damit gebildeten elektrischen Feld ein zweiter Bereich der Leiteranordnung des Prüflings geprüft wird.

EP 0 508 062 B1

**30.** Vorrichtung nach einem der vorhergehenden Ansprüche, **dadurch gekennzeichnet**, daß der Prüfling selbst eine Elektrodenanordnung (1) für die Prüfung seiner Leiteranordnung aufweist.

**31.** Vorrichtung nach einem der vorhergehenden Ansprüche, **dadurch gekennzeichnet**, daß die Elektrodenanordnung (1) von mindestens einer Leiterschicht einer Multilayer-Leiterplatte gebildet ist, die in mindestens einer anderen Schicht die zu prüfende Leiteranordnung aufweist.


**Claims**

**1.** A method for testing an electrical conductor arrangement, in particular, of conducting tracks of a printed circuit board, on short-circuit and/or interruption, wherein measurement results from test points of the conductor arrangement are determined and evaluated, **characterised in that** the conductor arrangement is acted upon by a non-uniform electric field and at least one electric potential forming as a result of the non-uniform electric field and from the measuring probes (3) is reduced at the individual test points and/or is compared with a reference.

**2.** A method according to Claim 1, **characterised in that** the electric field is produced by means of an electrode arrangement (1).

**3.** A method for testing an electrical conductor arrangement on short-circuit and/ or interruption, **characterised in that** at least one test point of the conductor arrangement is acted upon by electric voltage for creating a non-uniform electric field which, as a result of the field strength thereof at one electrode arrangement (1), produces at least one electric potential which is detected and evaluated.

**4.** A method according to Claim 3, **characterised in that** evaluation is carried out by comparing reference quantities.

**5.** A method according to one of the preceding claims, **characterised by** connecting means, connectable to the conductor arrangement, for supplying and removing testing currents.

**6.** A method according to one of the preceding claims, **characterised in that** to determine the measurement results, measuring probes (3) are used which form the connecting means.

**7.** A method according to one of the preceding claims, **characterised in that** a measuring probe (3) or a plurality of measuring probes (divided measuring probes 3) are used which have a multipart, in particular two-piece, measuring tip with tip regions (halves 31, 32) arranged adjacent each other and electrically insulated from each other.

**8.** A method according to Claim 7, **characterised in that** the measuring probe (3) is divided lengthwise by means of an insulating layer (30).

**9.** A method according to one of the preceding claims, **characterised in that** a four-wire measurement ("Guarding") is carried out with the divided measuring probe (3).

**10.** A method according to one of the preceding claims, **characterised in that** for testing fault contacts, bad contacts, for testing the positioning accuracy of the divided measuring probe (3) with respect to the respective test point of the conductor arrangement and/ or for testing the position of the test piece relative to the test device, a test circuit is produced between the two tip areas, wherein the test current flows across the contact points of the two tip areas and a conductor area of the respective test point.

**11.** A method according to Claim 10, **characterised in that** for establishing perfect or defective positioning and/or by carrying out a position correction of the test piece resulting in relation to the test arrangement, at least one divided measuring probe (3) is mounted on the conductor arrangement and the test circuit is activated, and if there is an interrupted test circuit as a result of a lateral misalignment of the measuring probe with respect to the corresponding conductor of the conductor arrangement, an alarm message and/ or a position correction of the test piece occurs until the test circuit flows satisfactorily.

**12.** A method according to Claim 11, **characterised in that** a plurality of different areas of the conductor arrangement are acted upon using a divided measuring probe (3).

10

13. A method according to one of the preceding claims, **characterised in that** the test piece for the test arrangement is positioned by optical comparison with a reference test piece, in particular a transparent reference plate.

14. A method according to one of the preceding claims, **characterised in that** the conductor arrangement has a plurality of nets (tracks) insulated from each other, the potential for each net is determined and stored, and the stored potentials are compared with each other by calculation, especially with the aid of a computer.

15. A method according to one of the preceding claims, **characterised in that** in the case of test points (N, M) belonging to a net, the respective potentials are determined and tested for equality.

16. A method according to one of the preceding claims, **characterised in that** in the case of test points (N, M) not belonging to a net the respective potentials are determined and tested for inequality.

17. A method according to one of the preceding claims, **characterised in that** a capacitance determination takes place by determining the current supplying the conductor arrangement and each conducting track.

18. A method according to one of the preceding claims, **characterised in that** determined capacitance values are used for testing short circuit and/or interruption by comparison with reference capacitance values.

19. A method according to one of the preceding claims, **characterised in that** the electrodes of the electrode arrangement (1) forming the electric field are connectable so as to be switchable over to electric voltages for the creation of the non-uniform field.

20. A method for testing an electrical conductor arrangement, especially of conducting tracks of a printed circuit board, on short-circuit and/or interruption, with measuring probes which are contactable with test points of the conductor arrangement and with an evaluation device **characterised by** an electrode arrangement (1) for creating a non-uniform electric field which acts upon the conductor arrangement and, on account of the electric field strength, produces an electric potential there which is supplied by means of the measuring probes (3) to the evaluation device (6).

21. A method according to one of the preceding claims, **characterised in that** the electrode arrangement (1) has a plurality of electrodes and corresponding voltages of a generator (8) are attached thereto for creating the non-uniform electric field.

22. A device according to one of the preceding claims, **characterised in that** the electrodes are formed by wires which are insulated from each other and span a testing plane which is used to contain a test piece having the conductor arrangement.

23. A device according to one of the preceding claims, **characterised in that** the electrodes are formed from conductors, in particular strip conductors, of a film or similar material.

24. A device according to Claim 23, **characterised in that** the film is held to the test piece by partial vacuum.

25. A device according to the Claims 23 and/ or 24, **characterised in that** the measuring probes (3) penetrate the film in order to contact the test piece.

26. A device according to one of the preceding claims, **characterised by** a positioning device and the measuring probes (3) are portable along the x and y co-ordinates by means thereof and are movable in the z direction in order to contact the conductor arrangement.

27. A device according to one of the preceding claims, **characterised in that** the electrodes of the electrode arrangement (1) are switched by means of a multiplexor (7).

28. A device according to one of the preceding claims, **characterised in that** the multiplexor (7) is actuated by the evaluation device (6) in order to switch it over.

29. A device according to one of the preceding claims, **characterised in that** a first area of a conductor arrangement of the test piece forms the electrode arrangement (1) and, using the electric field formed therewith, a second region of the conductor arrangement of the test piece is tested.

30. A device according to one of the preceding claims, **characterised in that** the test piece itself has an electrode arrangement (1) for testing the conductor arrangement thereof

31. A device according to one of the preceding claims, **characterised in that** the electrode arrangement (1) is formed from at least one layer of conductors of a multilayer printed circuit board which has the conductor arrangement to be tested in at least one other layer.

**Revendications**

1. Procédé pour tester un arrangement de conducteurs électriques, notamment des pistes conductrices d'une plaquette imprimée, en ce qui concerne les courts-circuits et/ou les interruptions, des résultats de mesure de points de test de l'arrangement de conducteurs étant établis et évalués, **caractérisé** en ce que l'arrangement de conducteurs est sollicité par un champ électrique non homogène, et en ce qu'au moins un potentiel électrique, qui se forme sur la base du champ électrique non homogène, est prélevé par les sondes de mesure (3) aux différents points de test et comparé au potentiel d'autres points de test et/ou à une référence.

2. Procédé selon la revendication 1, **caractérisé** en ce que le champ électrique est produit au moyen d'un arrangement d'électrodes (1).

3. Procédé pour tester un arrangement de conducteurs électriques en ce qui concerne les courts-circuits et/ou les interruptions, **caractérisé** en ce qu'au moins un point de test de l'arrangement de conducteurs est sollicité par une tension électrique pour établir un champ électrique non homogène qui, sur la base de son intensité de champ, produit sur un arrangement d'électrodes (1) au moins un potentiel électrique qui est enregistré et évalué.

4. Procédé selon la revendication 3, **caractérisé** en ce que l'évaluation s'effectue par comparaison avec des grandeurs de référence.

5. Procédé selon une des revendications précédentes, **caractérisé** par des moyens de connexion qui peuvent être mis en contact avec l'arrangement de conducteurs pour amener et évacuer des courants de test.

6. Procédé selon une des revendications précédentes, **caractérisé** en ce qu'on utilise pour l'établissement des résultats de mesure des sondes de mesure (3) qui constituent les moyens de connexion.

7. Procédé selon une des revendications précédentes, **caractérisé** en ce qu'on utilise une sonde de mesure (3) ou plusieurs sondes de mesure (sondes de mesure 3 en plusieurs parties), qui présentent une pointe de mesure en plusieurs parties, notamment en deux parties, avec des régions de pointe juxtaposées et électriquement isolées l'une par rapport à l'autre (moitiés 31, 32).

8. Procédé selon la revendication 7, **caractérisé** en ce que la sonde de mesure (3) est divisée longitudinalement au moyen d'une couche isolante (30).

9. Procédé selon une des revendications précédentes, **caractérisé** en ce qu'on effectue avec la sonde de mesure (3) en plusieurs parties une mesure à quatre fils ("guarding").

10. Procédé selon une des revendications précédentes, **caractérisé** en ce qu'un circuit de courant de test est produit entre les deux régions de la pointe afin de tester des mises en contact manquantes ou défectueuses, de tester la précision du positionnement de la sonde de mesure (3) en plusieurs parties par rapport au point de test respectif de l'arrangement de conducteurs, et/ou de tester la position de la pièce à tester par rapport au dispositif de test, le courant de test passant par les points de contact des deux régions de la pointe et par une région conductrice du point de test respectif.

11. Procédé selon la revendication 10, **caractérisé** en ce qu'afin de constater un positionnement correct ou défectueux, ou encore afin d'effectuer une correction de position de la pièce à tester s'effectuant par rapport à l'arrangement de test, au moins une sonde de mesure (3) en plusieurs parties est posée sur l'arrangement de conducteurs et le circuit de courant de test est activé, et en ce qu'en cas d'un circuit de courant de test interrompu, sur la base d'un décalage latéral de la sonde de mesure vers le conducteur correspondant de l'arrangement de conducteurs, une signalisation de défaillance et/ou une correction de position de la pièce à tester s'effectue jusqu'à ce que le courant de test s'écoule correctement.

12. Procédé selon la revendication 11, **caractérisé** en ce que plusieurs régions différentes de l'arrangement de conducteurs sont sollicitées par une sonde de mesure (3) en plusieurs parties.

13. Procédé selon une des revendications précédentes, **caractérisé** en ce que le positionnement de la pièce à tester par rapport à l'arrangement de test est effectué par comparaison optique avec une pièce à tester de référence, notamment une plaquette de référence transparente.

14. Procédé selon une des revendications précédentes, **caractérisé** en ce que l'arrangement de conducteurs présente plusieurs réseaux (files de conducteurs) isolés les uns des autres, en ce qu'on détermine et mémorise le potentiel pour chaque réseau, et en ce que les potentiels mémorisés sont comparés entre eux par le calcul, notamment à l'aide d'un ordinateur.

15. Procédé selon une des revendications précédentes, **caractérisé** en ce que, pour des points de test (N, M) faisant partie d'un réseau, on détermine les potentiels respectifs et on contrôle leur égalité.

16. Procédé selon une des revendications précédentes, **caractérisé** en ce que, pour des points de test (N, M) ne faisant pas partie d'un réseau, on détermine les potentiels respectifs et on contrôle leur inégalité.

17. Procédé selon une des revendications précédentes, **caractérisé** en ce qu'on effectue une détermination de capacité en déterminant le courant qui s'écoule vers l'arrangement de conducteurs ou encore vers chaque piste conductrice.

18. Procédé selon une des revendications précédentes, **caractérisé** en ce que les valeurs de capacité déterminées sont utilisées, par comparaison avec des valeurs de capacité de référence, pour tester la présence de courts-circuits et/ou d'interruptions.

19. Procédé selon une des revendications précédentes, **caractérisé** en ce que les électrodes de l'arrangement d'électrodes (1) formant le champ électrique peuvent être raccordées de manière commutable à des tensions électriques afin d'établir le champ non homogène.

20. Dispositif pour tester un arrangement de conducteurs électriques, notamment des pistes conductrices d'une plaquette imprimée, en ce qui concerne les courts-circuits et/ou les interruptions, avec des sondes de mesure qui peuvent être mises en contact avec des points de test de l'arrangement de conducteurs et avec un dispositif évaluateur, **caractérisé** par un arrangement d'électrodes (1) pour établir un champ électrique non homogène, qui sollicite l'arrangement de conducteurs et y produit, sur la base de l'intensité de champ électrique, un potentiel électrique qui est amené au moyen des sondes de mesure (3) au dispositif évaluateur (6).

21. Dispositif selon la revendication 20, **caractérisé** en ce que l'arrangement d'électrodes (1) présente une pluralité d'électrodes auxquelles sont connectées des tensions correspondantes d'un générateur (8) afin d'établir le champ électrique non homogène.

22. Dispositif selon une des revendications précédentes, **caractérisé** en ce que les électrodes sont formées par des fils métalliques qui couvrent, en étant isolés les uns des autres, un plan de test qui sert à recevoir une pièce à tester présentant l'arrangement de conducteurs.

23. Dispositif selon une des revendications précédentes, **caractérisé** en ce que les électrodes sont formées par des conducteurs, notamment des bandes conductrices, d'une feuille ou similaire.

24. Dispositif selon la revendication 23, **caractérisé** en ce que la feuille est maintenue par dépression sur la pièce à tester.

25. Dispositif selon une des revendications 23 et/ou 24, **caractérisé** en ce que les sondes de mesure (3) traversent la feuille pour mettre en contact la pièce à tester.

26. Dispositif selon une des revendications précédentes, **caractérisé** par un dispositif de positionnement au moyen duquel les sondes de mesure (3) peuvent être déplacées le long de coordonnées x et y, et dans une direction z pour la mise en contact de l'arrangement de conducteurs.

27. Dispositif selon une des revendications précédentes, **caractérisé** en ce que la commutation des électrodes de l'arrangement d'électrodes (1) s'effectue au moyen d'un multiplexeur (7).

28. Dispositif selon une des revendications précédentes, **caractérisé** en ce que le multiplexeur (7) est asservi par le dispositif évaluateur (6) pour la commutation.

29. Dispositif selon une des revendications précédentes, **caractérisé** en ce qu'une première région de l'arrangement de conducteurs de la pièce à tester constitue l'arrangement d'électrodes (1), et en ce qu'avec le champ électrique ainsi formé, on teste une deuxième région de l'arrangement de conducteurs de la pièce à tester.

30. Dispositif selon une des revendications précédentes, **caractérisé** en ce que la pièce à tester présente elle-même un arrangement d'électrodes (1) en vue de tester son arrangement de conducteurs.

31. Dispositif selon une des revendications précédentes, **caractérisé** en ce que l'arrangement d'électrodes (1) est formé par au moins une couche conductrice d'une plaquette imprimée multicouches, qui présente dans au moins une autre couche l'arrangement de conducteurs à tester.

Fig. 1

Fig. 2

Fig. 3

Fig. 4

Fig. 5

Fig. 6

Fig. 7

Fig. 8

Fig. 9

Fig. 10